# EUROPÄISCHE PATENTSCHRIFT

(11) **EP 2 721 619 B1**
(45) Veröffentlichungstag und Bekanntmachung des Hinweises auf die Patenterteilung: **27.09.2017**
(21) Anmeldenummer: 12748027.5
(22) Anmeldetag: 14.08.2012
(51) Int. Cl.: H01F 6/04, F25D 19/00, G01R 33/3815

(54) **VORRICHTUNG UND VERFAHREN ZUM KÜHLEN EINER EINRICHTUNG**
DEVICE AND METHOD FOR COOLING A UNIT
DISPOSITIF ET PROCÉDÉ POUR REFROIDIR UN ÉQUIPEMENT

(30) Priorität: 08.09.2011 DE 102011082352
(43) Veröffentlichungstag der Anmeldung: 23.04.2014
(73) Patentinhaber: Siemens Aktiengesellschaft, 80333 München (DE)
(72) Erfinder: SCHMIDT, Heinz, 91096 Möhrendorf (DE)
(86) Internationale Anmeldenummer: PCT/EP2012/065893
(87) Internationale Veröffentlichungsnummer: WO 2013/034408

(56) Entgegenhaltungen:
- EP-A2- 0 797 059
- DE-A1- 3 621 562
- DE-A1-102004 061 869
- DE-C1- 10 210 524
- GB-A- 2 461 393
- GB-A- 2 461 893
- JP-A- 7 142 242
- US-A1- 2004 056 541
- US-A1- 2009 254 227
- US-A1- 2010 089 073
- US-A1- 2010 248 968
- US-A1- 2011 133 871
- US-B1- 6 489 701

## Beschreibung

Die vorliegende Erfindung bezieht sich auf ein Verfahren und eine Vorrichtung zum Kühlen einer Einrichtung unter Verwendung eines Kaltkopfes, mit einer thermischen Kühlung der zu kühlenden Einrichtung über das Thermosiphon-Prinzip.

Zum Abkühlen von Einrichtungen, wie z.B. supraleitenden Spulen auf tiefe Temperaturen, werden häufig Kaltköpfe verwendet. Supraleitende Spulen können z.B. in Magnetspin-Tomographen, in Motoren, in Generatoren oder in Strombegrenzern eingesetzt werden. Dabei wird auf Temperaturen von bis zu unter 100K gekühlt. Insbesondere bei der Verwendung von Hochtemperatur-Supraleitenden (HTS)-Materialien, wie z.B. Y₂BaCu₃O₇ (YBCO), werden schon bei Temperaturen des flüssigen Stickstoffs supraleitende Eigenschaften der Leiter erreicht.

Anforderungen an das Kühlsystem beim Kühlen einer Einrichtung sind unter anderem eine kurze Abkühlzeit, ein niedriger Temperaturgradient innerhalb der zu kühlenden Einrichtung und/oder eine kleine Temperaturdifferenz zwischen Kaltkopf und zu kühlender Einrichtung. Im Weiteren wird die Kühlung einer Einrichtung mit Hilfe eines Kaltkopfes beschrieben. Darunter ist selbstverständlich analog zu verstehen die Kühlung mehrerer Einrichtungen mit einem Kaltkopf, einer Einrichtung mit mehreren Kaltköpfen oder mehrere Einrichtungen mit mehreren Kaltköpfen.

Zum Kühlen einer Einrichtung mit einem Kaltkopf muss die zu kühlende Einrichtung mit dem Kaltkopf thermisch verbunden sein. Zum thermischen ankoppeln des Kaltkopfes an die zu kühlende Einrichtung gibt es unterschiedliche Verfahren. So kann entweder die zu kühlende Einrichtung mit Hilfe einer Wärmebrücke über Wärmeleitung an den Kaltkopf thermisch angekoppelt werden. Alternativ ist aus dem Stand der Technik eine thermische Kopplung der zu kühlenden Einrichtung mit Hilfe eines Thermosiphons bekannt.

Bei der thermischen Kopplung der zu kühlenden Einrichtung mit Hilfe einer Wärmebrücke wird der Kaltkopf über Kupferschienen oder Kupferbänder mit der zu kühlenden Einrichtung verbunden. Da der Kaltkopf über Wärmeleitung mit der zu kühlenden Einrichtung in Verbindung steht, wird der Kaltkopf während dem Abkühlen auf einer Temperatur T gehalten, die relativ wenig unter der Temperatur T_{E} der Einrichtung liegt. Die Temperaturdifferenz ist von der Länge und vom Querschnitt der Verbindung zwischen Kaltkopf und zu kühlender Einrichtung abhängig.

Die Kühlleistung P eines Kaltkopfes nimmt mit der Kaltkopftemperatur T ab. Durch die geringe Temperaturdifferenz zwischen Kaltkopf und zu kühlender Einrichtung arbeitet der Kaltkopf beim Abkühlen des Systems stets in einem optimalen Temperaturbereich mit hoher Kühlleistung P. Die zu kühlende Einrichtung kann somit relativ schnell abgekühlt werden.

Damit im abgekühlten Zustand keine großen Temperaturgradienten in der zu kühlenden Einrichtung und zum Kaltkopf auftreten, sind entsprechend große Materialquerschnitte der Wärmebrücke notwendig. Dadurch kann es zu unzulässig hohen mechanischen Belastungen des empfindlichen Kaltkopfes kommen. Großen Temperaturgradienten im abgekühlten Zustand in der zu kühlenden Einrichtung und zum Kaltkopf sind zu verhindern, da diese zu einem schlechten Wirkungsgrad bei der Kühlung führen.

Bei der thermischen Kopplung der zu kühlenden Einrichtung mit Hilfe eines Thermosiphon wird ein gasförmiges Fluid, insbesondere Neon, in einem Kondensor verflüssigt. Der Kondensor sollte gut wärmeleitend mit dem Kaltkopf verbunden sein. Das flüssige Fluid fließt zur zu kühlenden Einrichtung und kann dort durch Übergang in den gasförmigen Zustand Wärme aufnehmen. Da das Kondensieren und Verdampfen des Fluids im gesamten System nahezu bei der gleichen Temperatur erfolgt, entstehen nur sehr kleine Temperaturgradienten innerhalb der zu kühlenden Einrichtung und zum Kaltkopf. Die Arbeitstemperatur des Kaltkopfes liegt dadurch jedoch immer bei der Siedetemperatur des verwendeten Kühlmediums.
Eine supraleitende Vorrichtung mit einem Rotor mit einer supraleitenden Wicklung, die mit einer nach dem Thermosiphon-Prinzip arbeitenden Kühlvorrichtung gekühlt wird, ist beispielsweise aus der US2004/0056541A1 bekannt. Ein Kaltkopf einer Kälteeinheit ist hier mit einer Kondensor-Einheit verbunden, in der ein Kühlmittel kondensiert wird. Das Kühlmittel wird durch ein abgedichtetes, feststehendes Wärmerohr axial in einen Hohlraum des Rotors eingeleitet. Die thermische Kopplung zwischen den feststehenden Teilen und den rotierenden _Teilen des Kühlsystems wird hier durch das eingespeiste flüssige Kühlmittel und das wieder ausgeleitete gasförmige Kühlmittel vermittelt. Ein gleichartiger Stand der Technik ist auch aus US-2011/0133871 A1 bekannt. Da der Kaltkopf bei der Thermosiphon-Kühlung auch während der gesamten Abkühldauer auf tiefer Temperatur T liegt, liefert er in dieser Zeit nur eine relativ geringe Kühlleistung P. Dadurch dauert das Abkühlen des zu kühlenden Objekts relativ lange.

Aufgabe der vorliegenden Erfindung ist es deshalb, ein Verfahren und eine Vorrichtung zum Kühlen einer Einrichtung anzugeben, welche einen hohen Wirkungsgrad bei der Kühlung der zu kühlenden Einrichtung aufweisen und gleichzeitig eine kurze Abkühlzeit erlauben.

Die angegebene Aufgabe wird bezüglich des Verfahrens zum Kühlen einer Einrichtung mit den Merkmalen des Anspruchs 1 und bezüglich der Vorrichtung zum Kühlen einer Einrichtung mit den Merkmalen des Anspruchs 6 gelöst.

Vorteilhafte Ausgestaltungen des erfindungsgemäßen Verfahrens zum Kühlen einer Einrichtung und der erfindungsgemäßen Vorrichtung zum Kühlen einer Einrichtung gehen aus den jeweils zugeordneten abhängigen Unteransprüchen hervor. Dabei können die Merkmale der nebengeordneten Ansprüche untereinander und mit Merkmalen der Unteransprüche und Merkmale der Unteransprüche untereinander kombiniert werden.

Das erfindungsgemäße Verfahren zum Kühlen einer Einrichtung unter Verwendung eines Kaltkopfes ist wie in Anspruch 1 beschrieben. Dadurch wird ein hoher Wirkungsgrad bei der Kühlung der zu kühlenden Einrichtung erreicht bei gleichzeitig kurzer Abkühlzeit. Durch die Verbindung über Wärmeleitung wird der Kaltkopf beim Abkühlen des Systems auf einem hohen Temperaturniveau gehalten. Beim Abkühlen des Systems liefert der Kaltkopf so eine hohe Kühlleistung P und arbeitet mit einem relativ guten Wirkungsgrad. Die zur Verfügung stehende Kühlleistung P nimmt erst ab, wenn auch die Wärmekapazität Q des zu kühlenden Objekts abnimmt. Dadurch wird eine kurze Abkühlzeit erreicht.

Bei der Siedetemperatur des Kühlmediums übernimmt der Thermosiphon die Kühlung der zu kühlenden Einrichtung. Die Temperaturdifferenz zwischen der zu kühlenden Einrichtung und dem Kaltkopf wird dadurch sehr klein, so dass der Kaltkopf bei optimaler Kühlleistung P und Wirkungsgrad arbeitet. Durch die Kühlung mit einem siedenden Kühlmedium kann auch in räumlich ausgedehnten Objekten ein kleiner Temperaturgradient erreicht werden.

Als Fluid kann Neon, Helium oder Stickstoff verwendet werden. Dabei ist die Wahl des Fluids abhängig von der zu erreichenden und zu haltenden Temperatur T_{E} der zu kühlenden Einrichtung. Das Fluid mit seinem Siedepunkt bestimmt die Temperatur T_{E}, bei welcher die zu kühlende Einrichtung nach Abkühlung gehalten wird. So ist z.B. bei Verwendung von YBCO in einer supraleitenden Einrichtung zum Aufrechterhalten der supraleitenden Eigenschaften Stickstoff als Fluid geeignet.

Der Kaltkopf kann bei Abkühlung der zu kühlenden Einrichtung über die Wärmebrücke auf einer Temperatur T größer der Siedetemperatur des Fluids gehalten werden und bei Erreichen der Siedetemperatur des Fluids erfolgt dann die Kühlung der zu kühlenden Einrichtung im Wesentlichen über das Thermosiphon-Prinzip. Dadurch wird bei Abkühlung eine kurze Abkühlzeit erreicht und beim Betrieb der zu kühlenden Einrichtung im gekühlten Zustand ein hoher Wirkungsgrad erreicht. Die Wärmebrücke kann dabei einen kleinen Querschnitt aufweisen.

Als mechanische Wärmebrücke kann ein Metall, insbesondere Kupfer verwendet werden. Kupfer weist eine hohe Wärmeleitfähigkeit auf und ist somit gut geeignet, einen guten Wärmetransport zwischen Kaltkopf und zu kühlender Einrichtung zu gewährleisten.

Es kann eine schienenförmige und/oder eine bandförmige mechanische Wärmebrücke verwendet werden. Diese Formen weisen einen großen Wärmeleitquerschnitt bei geringem Gewicht, wenig Materialverbrauch und hoher mechanischer Stabilität auf.

Eine erfinderische Vorrichtung zum Kühlen einer Einrichtung umfasst einen Kaltkopf, wie in Anspruch 6 beschrieben ist. Als Fluid kann Neon, Helium oder Stickstoff vorgesehen sein.

Der Kaltkopf kann auf einer Temperatur T größer der Siedetemperatur des Fluids bei Abkühlung der zu kühlenden Einrichtung über die Wärmebrücke gehalten werden. Über den Thermosiphon kann bei einer Temperatur T_{E} der zu kühlenden Einrichtung gleich der Siedetemperatur des Fluids der Kaltkopf und die zu kühlende Einrichtung im Wesentlichen auf gleicher Temperatur gehalten werden.

Die mechanische Wärmebrücke kann bei der erfindungsgemäßen Vorrichtung aus Metall, insbesondere aus Kupfer sein.

Die mechanische Wärmebrücke kann schienenförmig und/oder bandförmig sein.

Die mechanische Wärmebrücke kann Mehrteilig ausgelegt sein, insbesondere aufgebaut aus mehreren einzelnen schienen- und/oder bandförmigen Wärmebrücken. Dadurch kann eine bessere räumliche Verteilung der Masse der Wärmebrücke erreicht werden. Es kann auch ein größerer Wärmeleitquerschnitt als bei Verwendung von nur einer Wärmebrücke erreicht werden. Die Wärmebrücke bzw. Wärmebrücken können mit einem kleineren Querschnitt ausgelegt sein als Wärmebrücken in Vorrichtungen ohne Thermosiphon, da ab einer Temperatur T_{E} der zu kühlenden Einrichtung gleich der Temperatur T des Kaltkopfes im Wesentlichen die Kühlung über das Thermosiphon-Prinzip erfolgt.

Mehrere Thermosiphons können vorgesehen sein zum transportieren des flüssigen Fluids zur zu kühlenden Einrichtung und zum transportieren des gasförmigen Fluids von der zu kühlenden Einrichtung zum Kondensor. Dadurch kann ein besserer Wärmetransport im Vergleich zur Verwendung nur eines Thermosiphons erreicht werden.

Die zu kühlende Einrichtung kann einen Supraleiter, insbesondere in Form wenigstens einer supraleitenden Spule, umfassen.

Die mit der Vorrichtung zum Kühlen einer Einrichtung verbundenen Vorteile sind analog den Vorteilen, welche zuvor im Bezug auf das Verfahren zum Kühlen einer Einrichtung beschrieben wurden.

Bevorzugte Ausführungsformen der Erfindung mit vorteilhaften Weiterbildungen gemäß den Merkmalen der abhängigen Ansprüche werden nachfolgend anhand der Figuren näher erläutert, ohne jedoch darauf beschränkt zu sein.

Es wird in den Figuren dargestellt:
- Fig. 1: eine schematische Schnittdarstellung durch eine erfindungsgemäße Vorrichtung 1 zum Kühlen einer zu kühlenden Einrichtung 2 mit mechanischer Wärmebrücke 5 und Kondensor mit Thermosiphon 4, und
- Fig. 2: ein Diagramm der Kaltkopf-Kühlleistung P in Abhängigkeit von der Kaltkopf-Temperatur T, und
- Fig. 3: ein Diagramm der Kühlleistung P in Abhängigkeit von der Temperatur T_{E} der zu kühlenden Einrichtung 2, und
- Fig. 4: ein Diagramm der Kaltkopf-Temperatur T in Abhängigkeit von der Temperatur T_{E} der zu kühlenden Einrichtung 2.

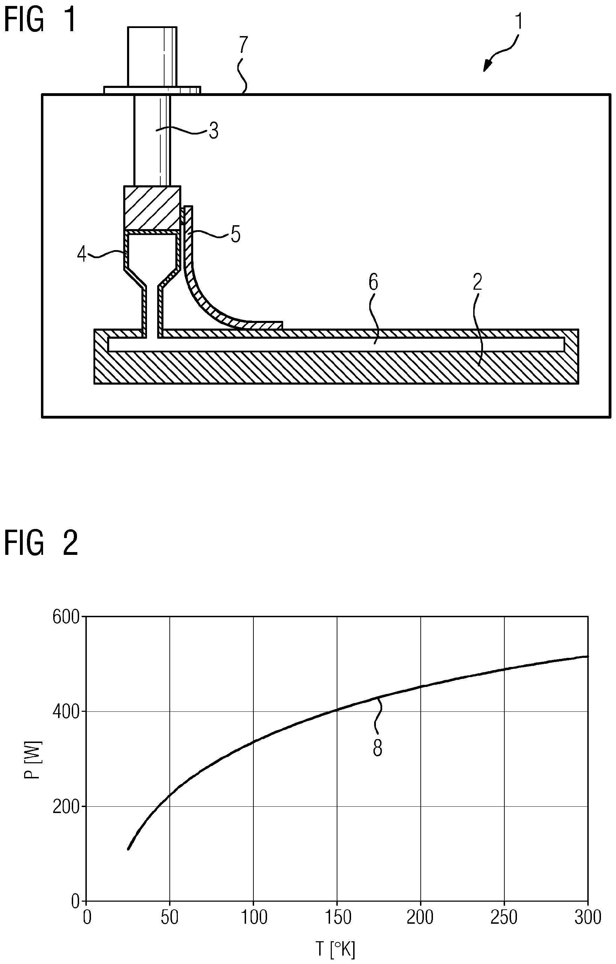

In der Fig. 1 ist eine schematische Schnittdarstellung durch eine erfindungsgemäße Vorrichtung 1 zum Kühlen einer zu kühlenden Einrichtung 2 dargestellt. Die Vorrichtung 1 umfasst einen Kaltkopf 3, welcher über einen Kondensor mit Thermosiphon 4 und über eine mechanische Wärmebrücke 5 mit der zu kühlenden Einrichtung 2 thermisch verbunden ist. Im Ausführungsbeispiel der Fig. 1 ist jeweils nur ein Kaltkopf 3, eine mechanische Wärmebrücke 5 und ein Kondensor mit Thermosiphon 4 dargestellt. Die Erfindung umfasst aber auch Ausführungsbeispiele mit mehreren Kaltköpfen 3 und/oder mehreren mechanischen Wärmebrücken 5 und/oder mehreren Kondensoren mit Thermosiphons 4, welche der Einfachheit halber in den Figuren nicht dargestellt sind.

Der Kaltkopf 3 in Fig. 1 ist direkt mit dem Kondensor 4 thermisch und mechanisch verbunden, wobei der Kondensor 4 einen Thermosiphon 4 umfasst. Nach dem Thermosiphon-Prinzip kondensiert ein Fluid, z.B. Neon, Stickstoff oder Helium, an dem Kaltkopf 4 und wird in flüssiger Form zu der zu kühlenden Einrichtung 2 transportiert, wo es verdampft. Der Transport kann durch Gravitation und/oder durch z.B. Pumpen oder Druckunterschiede erfolgen. Beim Kondensieren gibt das Fluid eine Wärmemenge ab, welche es beim Verdampfen wieder aufnimmt. Damit wird Kälteleistung über das flüssige Fluid vom Kaltkopf 3 zu der zu kühlenden Einrichtung 2 transportiert, und an die zu kühlende Einrichtung 2 abgegeben, wobei sich diese abkühlt oder durch die Kälteleistung auf einer konstanten niedrigen Temperatur kleiner der Umgebungstemperatur der zu kühlenden Einrichtung 2 gehalten wird.

In der Fig. 1 ist nur ein stark vereinfachter Aufbau eines Kondensors mit Thermosiphon 4 gezeigt, welcher eine Kondensorkammer in thermischen Kontakt mit dem Kaltkopf 3, einen rohrförmigen Abschnitt und ein Volumen bzw. eine Kammer in thermischen Kontakt mit der zu kühlenden Einrichtung 2 umfasst, in welchen das Fluid in flüssiger und gasförmiger Form strömen kann. Aus dem Stand der Technik sind unterschiedliche Aufbauten von Thermosiphon-Systemen bekannt, welche mit der vorliegenden Erfindung kombiniert werden können. So können z.B. Systeme mit zwei parallelen rohrförmigen Abschnitten einen besseren getrennten Transport von flüssigem und gasförmigen Fluid ermöglichen. Das System kann ein abgeschlossenes, ein geschlossenes oder ein offenes System sein, welches an eine Kältemaschine und/oder einen Fluid-Vorratsbehälter angeschlossen ist. Es sind auch fluiddichte Übergänge von ortsfesten zu drehbaren Teilen innerhalb des Systems möglich. So ist z.B. ein Wärmetransport von einem drehbaren Rotor einer Maschine als zu kühlende Einrichtung 2 zu einer ortsfesten, nicht rotierenden Kältequelle mit angeschlossenem Kaltkopf 3 möglich. Dabei ist eine Verbindung von einem drehbaren zu einem ortsfesten Teil mit erhöhtem Aufwand und verringerter Wärmeleitung über die mechanische Wärmebrücke verbunden, prinzipiell ist eine Anwendung auf diese Systeme jedoch möglich. Weitere, aus dem Stand der Technik bekannte Ausführungsformen sind mit der erfindungsgemäßen Vorrichtung ebenfalls kombinierbar.

Wie in Fig. 1 dargestellt kann ein Vakuumbehälter 7 vorgesehen sein, den Kaltkopf 3, den Kondensor mit Thermosiphon 4, die Wärmebrücke 5 und die zu kühlende Einrichtung 2 zu umschließen. Dadurch kann ein Wärmeaustausch der warmen Umgebung mit dem Kaltkopf 3, dem Kondensor mit Thermosiphon 4, der Wärmebrücke 5 und der zu kühlenden Einrichtung 2 unterbunden bzw. stark eingeschränkt werden. Alternativ kann der Vakuumbehälter 7 auch nur um die zu kühlende Einrichtung 2 und das Volumen 6 angeordnet sein oder andere Bereiche mit einschließen.

Wie zuvor beschrieben findet in der erfindungsgemäßen Vorrichtung 1 durch den Kondensor mit Thermosiphon 4 ein Wärmetransport von der zu kühlenden Einrichtung 2 zu dem Kaltkopf 3 mit z.B. angeschlossener Kältemaschine statt. Gleichzeitig erfolgt über Wärmeleitung ein Wärmetransport von der zu kühlenden Einrichtung 2 über die mechanische Wärmebrücke 5 zum Kaltkopf 3. Die mechanische Wärmebrücke 5 kann z.B. aus einem gut wärmeleitendem Kupfer-Band oder -Rohr bestehen, welches mechanisch und thermisch leitend mit der zu kühlenden Einrichtung 1 auf einer Seite und mit dem Kaltkopf 3 auf der entgegen gesetzten Seite verbunden ist. Dadurch kann ein guter Wärmetransport zwischen zu kühlender Einrichtung 2 und Kaltkopf 3 über Wärmeleitung sichergestellt werden.

In Fig. 2 ist die typische erzielbare Kaltkopf-Kühlleistung P in W in Abhängigkeit von der Kaltkopf-Temperatur T in °K für einen üblicherweise verwendeten Kaltkopf 3 dargestellt. Mit sinkender Temperatur T nimmt die erzielbare Kühlleistung P erst nur etwas und dann stärker ab. Um einen hohen Wirkungsgrad beim Betrieb einer Vorrichtung 1 zum Kühlen einer Einrichtung 2 zu erzielen, bei welchem die Einrichtung 2 erst abgekühlt werden muss und dann auf der niedrigen Temperatur gehalten werden muss, ist es vorteilhaft wenn der Kaltkopf 3 bei einer möglichst hohen Temperatur T arbeiten kann. Dies wird erreicht, wenn die Temperaturdifferenz zwischen zu kühlender Einrichtung 2 und Kaltkopf 3 klein gehalten wird.

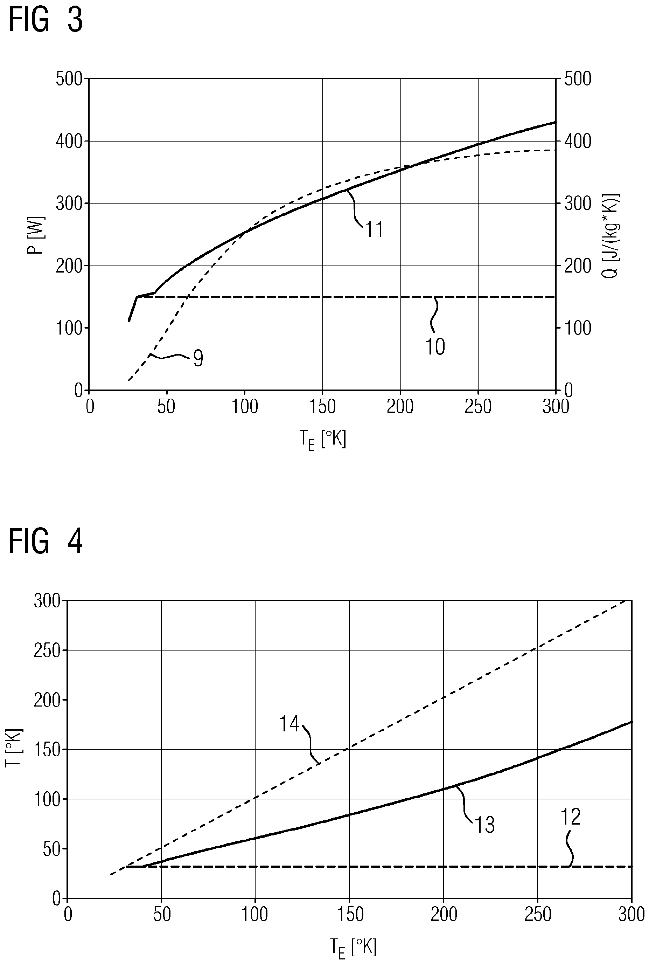

In Fig. 3 ist der mögliche Wärmetransport bzw. die mögliche zu transportierende Kühlleistung P mit einem mit Neon gefüllten Thermosiphon 4 dargestellt. Sie ist bis zu einer Temperatur T_{E} von ca. 30°K nahezu konstant. Bei gleichzeitiger Verwendung von Thermosiphon 4 und Wärmebrücke 5 wird der Kaltkopf 3 durch Wärmetransport über die Wärmebrücke 5 auf einem hohen Temperaturniveau gehalten, das nur relativ wenig unter der Temperatur T_{E} der zu kühlenden Einrichtung 2 liegt. Da außerdem die Wärmekapazität Q 9 der zu kühlenden Einrichtung 2 bei hoher Temperatur T_{E} um die 300°K groß ist und dann ab etwa 150°K mit sinkender Temperatur T_{E} stärker abfällt, wird ein großer Teil der zur Abkühlung abzuführenden Wärmemenge bei einer hohen Kaltkopftemperatur T, und damit bei einer großen verfügbaren Kühlleistung P abgeführt. Dies ermöglicht bei gleichzeitiger Verwendung von Thermosiphon 4 und Wärmebrücke 5 einen Transport von Kühlleistung P 11 abhängig von der Temperatur, welcher der erzielbaren Kühlleistung P eines typischen Kaltkopfs 3, wie in Fig. 2 dargestellt ist, nahezu entspricht. Somit arbeitet eine Vorrichtung mit einem Kaltkopf 3, einem Kondensor mit Thermosiphon 4 und gleichzeitig einer Wärmebrücke 5 zur Kühlung einer zu kühlenden Einrichtung 2 besonders effektiv, d.h. mit hohem Wirkungsgrad. Es geht nur wenig bis fast keine Kühlleistung P des Kaltkopfes 3 wegen mangelnder Transportmöglichkeit zur zu kühlenden Einrichtung 2 verloren.

In Fig. 4 ist die erzielbare Kaltkopf-Temperatur T 13 in °K an der zu kühlenden Einrichtung 2 mit der erfindungsgemäßen Vorrichtung 1 dargestellt. Bei einem Kaltkopf 3 in direktem Kontakt mit der zu kühlenden Einrichtung 2, ohne einen Temperaturgradienten durch Wärmetransport, würde bei der Abkühlung die gleiche Temperatur an der zu kühlenden Einrichtung 2 wie an dem Kaltkopf 3 vorliegen, siehe Kurve 14. Bei Verwendung nur des Kondensors mit Thermosiphon 4, ohne mechanische Wärmebrücke 5, ist nur eine sehr langsame Abkühlung möglich. Das Kondensieren und Verdampfen des Fluids erfolgt nahezu bei der gleichen Temperatur. Die Arbeitstemperatur des Kaltkopfes 3 liegt immer bei der Siedetemperatur des Fluids. Der Kaltkopf 3 liegt während der gesamten Abkühldauer auf tiefer Temperatur T und liefert somit nur eine geringe Kühlleistung P. Dadurch dauert das Abkühlen sehr lange.

Erst bei erfindungsgemäß zusätzlicher Verwendung einer Wärmebrücke 5 wird die Temperatur T des Kaltkopfs 3 auf ein hohes Niveau angehoben. Der Kaltkopf 3 kann schon beim Abkühlen stets in einem optimalen Temperaturbereich mit hoher Kühlleistung P arbeiten. Dadurch kann die zu kühlende Einrichtung 2 relativ schnell abgekühlt werden.

Ohne Thermosiphon 4 würde im abgekühlten Zustand ein hoher Querschnitt der Wärmebrücke 5 notwendig sein, um keine großen Temperaturgradienten in der zu kühlenden Einrichtung 2 und zum Kaltkopf 3 zu erhalten. Hohe Temperaturgradienten im abgekühlten Zustand in der zu kühlenden Einrichtung 2 und zum Kaltkopf 3 würden zu einem schlechten Wirkungsgrad führen. Deshalb sind diese zu vermeiden. Die zur Vermeidung notwendigen gossen Querschnitte der Wärmebrücke 5 können jedoch zu unzulässig hohen mechanischen Belastungen des empfindlichen Kaltkopfes 3 führen.

Durch die erfindungsgemäße gleichzeitige Verwendung eines Thermosiphons 4 und einer Wärmebrücke 5 können eine schnelle Abkühlung und ein hoher Wirkungsgrad auch im abgekühlten Zustand der zu kühlenden Einrichtung 2 miteinander verbunden werden. Die Wärmebrücke 5 sorgt für eine schnelle Abkühlung und im abgekühlten Zustand übernimmt das Thermosiphon-Prinzip die Kühlung der zu kühlenden Einrichtung 2. Ein großer Querschnitt der Wärmebrücke 5 ist nicht notwendig, und somit treten die zuvor beschriebene Nachteile, verbunden mit einem großen Querschnitt nicht auf.

Die erfindungsgemäße Vorrichtung 1 kann mit dem erfindungsgemäßen Verfahren betrieben werden. Zuvor beschrieben Ausführungsbeispiele sind untereinander und mit Ausführungsbeispielen, bekannt aus dem Stand der Technik kombinierbar. So können z.B. für die Wärmebrücke 5 auch Materialien wie Eisen, Stahl, gut wärmeleitende Plastik oder andere in Verbindung mit oder anstatt Kupfer verwendet werden. Die erfindungsgemäße Vorrichtung 1 ist auch für andere zu kühlende Einrichtungen 2 wie z.B. konventionelle statt supraleitende Maschinen einsetzbar.

Der wesentliche erfinderische Gedanke liegt in der thermischen Verbindung eines Kühlkopfes 3 mit einer zu kühlenden Einrichtung 2 über Wärmeleitung mit Hilfe einer Wärmebrücke 5 und gleichzeitig über das Thermosiphon-Prinzip mit Hilfe eines Kondensors mit Thermosiphon 4. Überraschender Weise behindern sich die unterschiedlichen Kühlprinzipien nicht, sondern ergänzen sich, wie die Diagramme in den Fig. 2 bis 4 darstellen. Der Einsatz nur eines Kühlprinzips, wie es im Stand der Technik als ausreichend angesehen wird zum Kühlen einer Einrichtung 2, führt zu keiner Kühlung mit kurzer Abkühlzeit und gleichzeitig gutem Wirkungsgrad auch bei weiterer Kühlung bei der zu erreichenden Temperatur. Erst durch die Verwendung der Kühlung über das Thermosiphon-Prinzip und über die Wärmeleitung mit Hilfe eine Wärmebrücke 5, ist eine kurze Abkühlzeit und ein guter Wirkungsgrad auch bei weiterer Kühlung zu erreichen.

## Patentansprüche

1. Verfahren zum Kühlen einer Einrichtung (2) unter Verwendung eines Kaltkopfes (3), mit einer thermischen Kühlung der zu kühlenden Einrichtung (2) über das Thermosiphon-Prinzip, wobei gleichzeitig eine Wärmeleitung über eine mechanische Wärmebrücke (5) erfolgt, welche den Kaltkopf (3) mechanisch und thermisch leitend direkt mit der zu kühlenden Einrichtung (2) verbindet, wobei ein Kondensor (4) in direktem thermischen und mechanischen Kontakt mit dem Kaltkopf (3) steht und gasförmiges Fluid am Kondensor (4) verflüssigt wird, das Fluid flüssig zur zu kühlenden Einrichtung (2) transportiert wird, und an oder nahe der zu kühlenden Einrichtung (2) in den gasförmigen Zustand unter Aufnahme von Wärmemenge übergeht.

2. Verfahren nach Anspruch 1, **dadurch gekennzeichnet, dass** als Fluid Neon, Helium oder Stickstoff verwendet wird.

3. Verfahren nach einem der Ansprüche 1 oder 2, **dadurch gekennzeichnet, dass** der Kaltkopf (3) bei Abkühlung der zu kühlenden Einrichtung (2) über die Wärmeleitfähigkeit der Wärmebrücke (5) auf einer Temperatur T größer der Siedetemperatur des Fluids gehalten wird und dass bei Erreichen der Siedetemperatur des Fluids die Kühlung der zu kühlenden Einrichtung (2) im Wesentlichen über das Thermosiphon-Prinzip erfolgt.

4. Verfahren nach einem der vorhergehenden Ansprüche, **dadurch gekennzeichnet, dass** als mechanische Wärmebrücke (5) ein Metall, insbesondere Kupfer verwendet wird.

5. Verfahren nach einem der vorhergehenden Ansprüche, **dadurch gekennzeichnet, dass** eine schienenförmige und/oder eine bandförmige mechanische Wärmebrücke (5) verwendet wird.

6. Vorrichtung (1) zum Kühlen einer Einrichtung (2) mit einem Kaltkopf (3), welcher mit der zu kühlenden Einrichtung (2) über das Thermosiphon-Prinzip thermisch verbunden ist, wobei eine mechanische Wärmebrücke (5) vorgesehen ist, über welche der Kaltkopf (3) mechanisch und thermisch leitend direkt mit der zu kühlenden Einrichtung (2) verbunden ist, **dadurch gekennzeichnet, dass** ein Kondensor (4) in direktem thermischen und mechanischen Kontakt mit dem Kaltkopf (3) vorgesehen ist zum verflüssigen von gasförmigem Fluid am Kondensor (4), ein Thermosiphon (4) vorgesehen ist zum transportieren des flüssigen Fluids zur zu kühlenden Einrichtung (2) und zum transportieren des gasförmigen Fluids von der zu kühlenden Einrichtung (2) zum Kondensor (4).

7. Vorrichtung (1) nach Anspruch 6, **dadurch gekennzeichnet, dass** das Fluid Neon, Helium oder Stickstoff ist.

8. Vorrichtung (1) nach Anspruch 6 oder 7, **dadurch gekennzeichnet, dass** durch die Wärmeleitfähigkeit der Wärmebrücke (5) der Kaltkopf (3) auf einer Temperatur T größer der Siedetemperatur des Fluids bei Abkühlung der zu kühlenden Einrichtung (2) ist und dass über den Thermosiphon (4), bei einer Temperatur T_{E} der zu kühlenden Einrichtung (2) gleich der Siedetemperatur des Fluids, der Kaltkopf (3) und die zu kühlende Einrichtung (2) im Wesentlichen auf gleicher Temperatur sind.

9. Vorrichtung (1) nach einem der Ansprüche 6 bis 8, **dadurch gekennzeichnet, dass** die mechanische Wärmebrücke (5) aus Metall, insbesondere aus Kupfer ist.

10. Vorrichtung (1) nach einem der Ansprüche 6 bis 9, **dadurch gekennzeichnet, dass** die mechanische Wärmebrücke (5) schienenförmig und/oder bandförmig ist.

11. Vorrichtung (1) nach einem der Ansprüche 6 bis 10, **dadurch gekennzeichnet, dass** die mechanische Wärmebrücke (5) Mehrteilig ausgelegt ist, insbesondere aufgebaut aus mehreren einzelnen schienen- und/oder bandförmigen Wärmebrücken (5).

12. Vorrichtung (1) nach einem der Ansprüche 6 bis 11, **dadurch gekennzeichnet, dass** mehrere Thermosiphons (4) vorgesehen sind zum transportieren des flüssigen Fluids zur zu kühlenden Einrichtung (2) und zum transportieren des gasförmigen Fluids von der zu kühlenden Einrichtung (2) zum Kondensor (4).

13. Vorrichtung (1) nach einem der Ansprüche 6 bis 12, **dadurch gekennzeichnet, dass** die zu kühlenden Einrichtung (2) Supraleiter, insbesondere in Form wenigstens einer supraleitenden Spule, umfasst.

## Claims

1. Method for cooling a unit (2) using a cold head (3) with a thermal cooling of the unit (2) to be cooled by means of the thermosiphon principle, wherein heat is conducted at the same time via a mechanical heat bridge (5), which provides a direct mechanical and thermal connection from the cold head (3) to the unit (2) to be cooled, wherein a condenser (4) is in direct thermal and mechanical contact with the cold head (3) and gaseous fluid is condensed at the condenser (4), the fluid is transported in liquid form to the unit (2) to be cooled, and passes into the gaseous state by absorbing a quantity of heat on or adjacent to the unit (2) to be cooled.

2. Method according to claim 1, **characterised in that** neon, helium or nitrogen is used as fluid.

3. Method according to one of claims 1 or 2, **characterised in that** the cold head (3) is kept at a temperature T of greater than the boiling temperature of the fluid when the unit (2) to be cooled is cooled down by way of the thermal conductivity of the heat bridge (5) and that when the boiling temperature of the fluid is reached, the cooling of the unit (2) to be cooled essentially takes place by means of the thermosiphon principle.

4. Method according to one of the preceding claims, **characterised in that** a metal, in particular copper, is used as a mechanical heat bridge (5).

5. Method according to one of the preceding claims, **characterised in that** a rail-shaped and/or band-shaped mechanical heat bridge (5) is used.

6. Device (1) for cooling a unit (2) with a cold head (3), which is thermally connected to the unit (2) to be cooled by means of the thermosiphon principle, wherein a mechanical heat bridge (5) is provided, by way of which the cold head (3) is directly mechanically and thermally connected to the unit (2) to be cooled, **characterised in that** a condenser (4) is provided in direct thermal and mechanical contact with the cold head (3) for condensing gaseous fluid on the condenser (4), a thermosiphon (4) is provided for transporting the liquid fluid to the unit (2) to be cooled and for transporting the gaseous fluid from the unit (2) to be cooled to the condenser (4).

7. Device (1) according to claim 6, **characterised in that** the fluid is neon, helium or nitrogen.

8. Device (1) according to claim 6 or 7, **characterised in that** the cold head (3) is at a temperature T of greater than the boiling temperature of the fluid when the unit (2) to be cooled is cooled down by way of the thermal conductivity of the heat bridge (5) and that by means of the thermosiphon (4), at a temperature T_{E} of the unit (2) to be cooled, which equates to the boiling temperature of the fluid, the cold head (3) and the unit (2) to be cooled are essentially at the same temperature.

9. Device (1) according to one of claims 6 to 8, **characterised in that** the mechanical heat bridge (4) is made of metal, in particular copper.

10. Device (1) according to one of claims 6 to 9, **characterised in that** the mechanical heat bridge (5) is rail-shaped or band-shaped.

11. Device (1) according to one of claims 6 to 10, **characterised in that** the mechanical heat bridge (5) is configured in multiple parts, in particular constructed from several individual rail-shaped and/or band-shaped heat bridges (5).

12. Device (1) according to one of claims 6 to 11, **characterised in that** a number of thermosiphons (4) are provided for transporting the liquid fluid to the unit (2) to be cooled and for transporting the gaseous fluid from the unit (2) to be cooled to the condenser (4)

13. Device (1) according to one of claims 6 to 12, **characterised in that** the unit (2) to be cooled includes a superconductor, in particular in the form of at least one superconducting coil.

## Revendications

1. Procédé de refroidissement d'un dispositif (2) en utilisant une tête (3) froide, comprenant un refroidissement thermique du dispositif (2) à refroidir par le principe du thermosiphon, dans lequel il s'effectue en même temps une conduction de chaleur par un pont (5) thermique mécanique, qui relie la tête (3) froide mécaniquement et d'une manière conductrice thermiquement directement au dispositif (2) à refroidir, un condenseur (4) étant en contact thermique et mécanique direct avec la tête (3) froide et du fluide gazeux étant liquéfié dans le condenseur (4), le fluide étant transporté sous forme liquide au dispositif (2) à refroidir et passant avec absorption d'une quantité de chaleur à l'état gazeux sur le dispositif (2) à refroidir ou à proximité de celui-ci.

2. Procédé suivant la revendication 1, **caractérisé en ce qu'**on utilise comme fluide du néon, de l'hélium ou de l'azote.

3. Procédé suivant l'une des revendications 1 ou 2, **caractérisé en ce que** l'on maintient la tête (3) froide lors du refroidissement du dispositif (2) à refroidir par la conductibilité thermique du pont (5) thermique à une température T plus haute que le point d'ébullition du fluide et **en ce que**, lorsque le point d'ébullition du fluide est atteint, le refroidissement du dispositif (2) à refroidir s'effectue essentiellement par le principe du thermosiphon.

4. Procédé suivant l'une des revendications précédentes, **caractérisé en ce qu'**on utilise comme pont (5) thermique mécanique un métal, notamment du cuivre.

5. Procédé suivant l'une des revendications précédentes, **caractérisé en ce que** l'on utilise un pont (5) thermique mécanique en forme de barre et/ou en forme de bande.

6. Système (1) de refroidissement d'un dispositif (2), comprenant une tête froide, laquelle est reliée thermiquement au dispositif (2) à refroidir par le principe du thermosiphon, dans lequel il est prévu un pont (5) thermique mécanique, par lequel la tête (3) froide est reliée mécaniquement et d'une manière conductrice de l'électricité directement au dispositif (2) à refroidir, **caractérisé en ce qu'**un condenseur (4) est prévu en contact direct thermique et mécanique avec la tête (3) froide pour liquéfier du fluide gazeux dans le condenseur (4), un thermosiphon (4) étant prévu pour transporter le fluide liquide au dispositif (2) à refroidir et pour transporter le fluide gazeux du dispositif (2) à refroidir au condenseur (4).

7. Système (1) suivant la revendication 6, **caractérisé en ce que** le fluide est du néon, de l'hélium ou de l'azote.

8. Système (1) suivant la revendication 6 ou 7, **caractérisé en ce que** par la conductibilité thermique du pont (5) thermique, la tête (3) froide est à une température T plus haute que le point d'ébullition du fluide lors du refroidissement du dispositif à refroidir et **en ce que**, par le thermosiphon (4) à une température T_{B} du dispositif (2) à refroidir égal au point d'ébullition du fluide, la tête (3) froide et le dispositif (2) à refroidir sont sensiblement à la même température.

9. Système (1) suivant l'une des revendications 6 à 8, **caractérisé en ce que** le pont (5) thermique mécanique est en métal, notamment en cuivre.

10. Système (1) suivant l'une des revendications 6 à 9, **caractérisé en ce que** le pont (5) thermique mécanique est en forme de barre et/ou en forme de bande.

11. Système (1) suivant l'une des revendications 6 à 10, **caractérisé en ce que** le pont (5) thermique mécanique est composé de plusieurs parties, en étant composé notamment de plusieurs ponts thermiques individuels en forme de barre et/ou en forme de bande.

12. Système (1) suivant l'une des revendications 6 à 11, **caractérisé en ce qu'**il est prévu plusieurs thermosiphons (4) pour transporter le fluide liquide au dispositif (2) à refroidir et pour transporter le fluide gazeux du dispositif (2) à refroidir au condenseur (4).

13. Système (1) suivant l'une des revendications 6 à 12, **caractérisé en ce que** le dispositif (2) à refroidir comprend un supraconducteur, notamment sous la forme d'au moins une bobine supraconductrice.
